# EUROPÄISCHE PATENTSCHRIFT

(11) **EP 1 520 458 B1**
(45) Veröffentlichungstag und Bekanntmachung des Hinweises auf die Patenterteilung: **19.04.2006**
(21) Anmeldenummer: 03762488.9
(22) Anmeldetag: 13.06.2003
(51) Int. Cl.: H05K 9/00

(54) **ELEKTRISCH GESCHIRMTER BAUGRUPPENTRÄGER**
ELECTRICALLY SHIELDED MODULE CARRIER
SUPPORT D'ENSEMBLES A BLINDAGE ELECTRIQUE

(30) Priorität: 08.07.2002 DE 10230704
(43) Veröffentlichungstag der Anmeldung: 06.04.2005
(73) Patentinhaber: SIEMENS AKTIENGESELLSCHAFT, 80333 München (DE)
(72) Erfinder: PLABST, Roland, 82239 Alling (DE)
(74) Vertreter: Berg, Peter
(86) Internationale Anmeldenummer: PCT/EP2003/006221
(87) Internationale Veröffentlichungsnummer: WO 2004/006641

(56) Entgegenhaltungen:
- WO-A-93/15595
- US-A- 5 027 089
- US-B1- 6 285 548
- US-B1- 6 325 472

## Beschreibung

### Technisches Gebiet

Die Erfindung betrifft einen elektrisch geschirmten Baugruppenträger zur Aufnahme elektrischer und/oder elektronischer Baugruppen mit einem Deckelteil und einem Bodenteil, mit zumindest einem Einbauraum, den eine Zwischenwandkarte in einen vorderen Raumabschnitt und in einen hinteren Raumabschnitt teilt und in jedem dieser Abschnitte seitlich Halterungen für eingeschobene Flachbaugruppen vorgesehen sind.

### Stand der Technik

Baugruppenträger dienen zur Aufnahme unterschiedlicher elektrischer und elektronischer Baueinheiten. In vielen Bereichen der Elektrotechnik, insbesondere im Bereich der Kommunikationstechnik, tritt das Problem auf, dass im Baugruppenträger der Einbauraum für elektronische Baueinheiten störstrahlsicher ausgeführt sein muss, andererseits aber auch elektrische Baukomponenten, wie beispielsweise Lüfter, Stromversorgung und Verkabelung in Baugruppenträger untergebracht werden müssen. Sofern diese elektrischen Baueinheiten nicht selbst als Störquelle anzusehen sind, erfordert ihre Unterbringung im Baugruppenträger vergleichsweise geringere schirmungstechnische Maßnahmen.

Abhängig vom abzuschirmenden Feldtyp sind in der Elektrotechnik verschiedene Bauformen und Ausführungen von Schirmgehäusen bekannt.

Zum Schutz vor elektrostatischen Einwirkungen und langsam veränderlichen Feldern ist.bekannt, das gesamte Gehäuse eines elektrischen Gerätes nach Art eines Faradayschen Käfigs auszuführen. Für diese Abschirmvorrichtungen werden üblicherweise Blechteile aus Stahl, Aluminium oder Sonderlegierungen verwendet, die durch mechanische und elektrische Verbindungen zu einer leitfähigen Schirmhülle zusammengefügt sind. Je nach technischer Ausführung dieser Verbindungen ist der zu schützenden Einbauraum im Idealfall feldfrei.

Bei einfallenden und ausfallenden elektromagnetischen Wellen ist die Schirmwirkung durch die Reflexion und die Transmission an Materialübergängen und durch die Absorption in der Schirmwand bestimmt. Um den Forderungen einer einwandfreien elektromagnetischen Abschirmung gerecht zu werden, müssen die Gehäuseteile durch eine Vielzahl von Kontaktpunkten mit jeweils möglichst niedrigem Übergangswiderstand verbunden sein. Konstruktiv heißt dies, eine Rundumkontaktierung der Fügebereiche mit eng beabstandeten Kontaktstellen. Die Herstellung dieser Rundumkontaktierung, die durch Punktschweißen, Schrauben, Nieten, Schirmfedern, Kontaktwarzen oder flexible elektrische Schlauchleitungen realisiert werden kann, ist entsprechend aufwendig.

Ein weiteres Problem entsteht durch die Forderung nach zunehmender Integrations- und Packungsdichte. Die bestückten Leiterplatten müssen sowohl von einer Vorder- als auch von einer Hinterseite in den Baugruppenrahmen einschiebbar sein, d.h. die am Baugruppenträger an der Front- und an der Rückseite vorhandenen Blenden, die in die Schirmung eingebunden sind, müssen abnehmbar sein. Bei dieser Bauform des Baugruppenträgers erfolgt die elektrische Verbindung der Leiterplatten durch eine quer zur Einschubrichtung angeordnete Verbindungskarte. Diese Verbindungskarte, die im folgenden als Zwischenwandkarte bezeichnet wird, wird in der Literatur auch als Midplane oder Double-sided Backplane bezeichnet. Sie ist meist mittig im Baugruppenträger angeordnet und beidseitig mit Steckverbindern versehen. In diese Steckverbinder sind die Leiterplatten einsteckbar. Ein gemeinsamer Bus stellt eine elektrische Verbindung zwischen den Einschüben her. Oft beinhaltet die Zwischenwandkarte auch aktive Baukomponenten und muss für Servicearbeiten zugänglich, bzw. demontierbar sein.
In Hinblick auf die Konstruktion des Baugruppenträgers bedeutet dies zunächst, dass der Einbauraum sowohl im vorderen als auch im hinteren Raumabschnitt, als ein hoch geschirmter Raum ausgeführt sein muss. Andererseits muss die Zwischenwandkarte zugänglich und bei der Montage möglichst einfach einzubauen sein. Wenn aus schirmungstechnischen Gründen auch die Zwischenwandkarte in die Abschirmung einzubinden ist, muss diese zuverlässig mit den geschirmten Gehäuseteilen kontaktiert sein.

Aus ökonomischer Sicht sollte der Schirmungsaufwand möglichst auf die jeweiligen Schirmungsanforderungen im Baugruppenträger abstimmbar sein. M.a.W. das Einbauvolumen, das EMV-technisch geringere Anforderungen stellt, sollte auch mit geringern Kosten realisiert werden können.

Der Baugruppenträger soll ferner in Großserie, möglichst mit üblichen Fertigungswerkzeugen, herstellbar sein.

Aus EP 0926937 ist ein Baugruppenrahmen mit mittig angeordneter Backplane bekannt. Die Backplane ist auf einem Backplaneträger montiert. Zur Montage der Backplane weist der Baugruppenrahmen im mittleren Bereich zwei als Drehachse dienende Erhebungen auf, die sowohl in seinem Deckelteil als auch in seinem Bodenteil angeordnet sind. Diese Erhebungen sind durch Einschwenken der Backplane in Ausschnitte des Backplaneträgers einschiebbar, wodurch die Backplane im mittleren Bereich des Baugruppenrahmens positionierbar ist. Die Herstellung des Baugruppenrahmens ist vergleichsweise aufwendig, da der Backplaneträger ein Zusatzteil mit zusätzlichen Herstellungskosten darstellt.

### Darstellung der Erfindung

Der Erfindung liegt die Aufgabe zu Grunde, mit geringem Aufwand einen Baugruppenträger zu schaffen, bei dem der Einbauraum für elektronische Baugruppen zuverlässig vor elektromagnetischer Störstrahlung geschirmt ist und der in großen Stückzahlen kostengünstig herstellbar ist.

Diese Aufgabe wird bei einem gattungsgemäßen Baugruppenträger durch die kennzeichnenden Merkmale des Patentanspruchs 1 gelöst. Auf vorteilhafte Ausgestaltungen der Erfindung nehmen die Unteransprüche Bezug.

Charakteristisch für die Erfindung ist mithin, dass die Halterung der Leiterplatten durch Führungsroste erfolgt, die im Einbauraum jeweils paarweise gegenüberliegend angeordnet und in eine elektromagnetische Abschirmung eingebunden sind, wobei ein Deckenteil und ein Bodenteil mit Führungsrosten in einem vorderen Raumabschnitt unlösbar und mit Führungsrosten in einem hinteren Raumabschnitt lösbar verbunden sind.
Indem die vorderen Führungsroste mit den Gehäuseschalen unlösbar verbunden sind, entsteht bei der Fertigung eine vormontierbare Einheit. Diese vormontierbare Einheit erleichtert die Montage der Zwischenwandkarte wesentlich: Die Zwischenwandkarte kann unter Einsatz herkömmlicher Handhabungssysteme ohne komplizierte Schwenkbewegung in den Einbauraum eingeschoben und durch Bohrschrauber montiert werden. Gegenüber dem Stand der Technik entfällt der Backplaneträger und bei der Montage auch das komplizierte Einrasten dieses Zusatzteils. Für die Herstellung in großen Stückzahlen ist dies von Vorteil.

Die Führungsroste erfüllen einerseits die Funktion der Halterung der Leiterplatten und bilden - EMV-technisch gesehen - seitliche Schirmwände. In einem Baugruppenträger können seitlich angrenzend, jeweils durch diese Schirmwände getrennt, mehrere solche hoch geschirmte Einbauräume angeordnet sein.

In einer vorteilhaften Ausgestaltung der Erfindung weist das Deckenteil und das Bodenteil jeweils seitlich fortgesetzt Abkantungen auf. Durch diese Abkantungen wird seitlich angrenzend an den hoch geschirmten Einbauraum, ein schwächer geschirmter Bauraum für elektrische Baugruppen, z.B.: Lüfter, Stromversorgungsbaugruppen oder Kaltgerätesteckdosen geschaffen. Dieser schwächer geschirmte Bauraum verursacht in der Herstellung geringere Kosten. Der Schirmungsaufwand ist auf die Schirmungsanforderungen besser abgestimmt.

Eine vorteilhafte Ausgestaltung der Erfindung sieht vor, dass die Führungsroste im vorderen Raumabschnitt jeweils an dem zur Zwischenwandkarte weisenden Ende jeweils mit einem Schenkel versehen sind und jeder Schenkel einen Anlageabschnitt für die Zwischenwandkarte bildet. Dadurch ist die Zwischenwandkarte gut kontaktiert und durch Schrauben leicht zu befestigen. Die Schrauben liegen in Einschubrichtung und sind für Automatikschrauber gut zugänglich.

Eine weitere Verbesserung der Schirmwirkung wird dadurch erreicht, dass die Führungsroste des hinteren Raumabschnittes jeweils an dem zur Zwischenwandkarte weisenden Ende mit zungenförmigen Zinken versehen sind, die in korrespondierende Ausnehmungen der Schenkel eingreifen und austrittseitig aus den Ausnehmungen vorstehende Enden plastisch verformt sind. Die plastische Verformung kann durch Prägen, Stauchen oder Schränken erfolgen. Eine Formschlussverbindung der Roste die durch Schränken hergestellt wird ist bevorzugt. Durch die Schränkverbindung gräbt sich im Kontraktbereich jede Zinke in der ihr zugeordneten Ausnehmung ein. Diese luftdichte Verbindung stellt sicher, dass in der Kontaktstelle die Ausbildung einer Oxidschicht sicher unterbunden wird. Während der Gebrauchsdauer bleibt in der Kontaktstelle ein gleich niedriger ohmscher Widerstand erhalten. Die Schränkverbindung ist durch ein automatisches Fertigungswerkzeug herstellbar, das bei eingesteckter Zinke auf das Endstück der Zinke greift und dieses Endstück verwindet. Bei der Montage erleichtert eine Anschrägung an den Zinken das Eintauchen in die jeweilige Ausnehmung.

Neben dieser formschlüssigen Verbindung ist auch denkbar, dass die Führungsroste jeweils an ihrem zur Zwischenwandkarte weisenden Ende einander überlappen und die Schirmwirkung durch diese Überlappung hergestellt wird.

Es ist von Vorteil, wenn das Deckenteil und das Bodenteil mit den Führungsrosten im vorderen Raumabschnitt verschweißt und mit den Führungsrosten des hinteren Raumabschnittes mittels einer Schraubverbindung verbunden ist. Durch die materialschlüssige Schweißverbindung wird nicht nur ein zuverlässiger elektrische Kontakt hergestellt, sondern es entsteht aus fertigungstechnischer Sicht gesehen eine vormontierte Einheit, die in der Produktion - verglichen mit Einzelteilen - wesentlich einfacher handhabbar ist. Das Schweißen kann kostengünstig durch eine automatisierte Schweißzange erfolgen, die in den Baugruppenträger von vorne eingreift und Abwinkelungen, die jeweils am Führungsrost boden- und deckenseitig angeordnet sind, mit dem Deckenteil bzw. dem Bodenteil verbindet. Der Abstand zwischen den Schweißpunkten kann bei automatisierten Schweißwerkzeugen auf einfache Weise vorgegeben werden. Ein Abstand der Schweißpunkte von etwa 25 mm hat sich für viele Anwendungen in der Praxis als EMV-technisch günstig herausgestellt.

Wenn die Flachbaugruppen im Einbauraum in parallel liegenden horizontalen Einschubebenen angeordnet sind, ist es günstig, an den Führungsrosten Ausnehmungen vorzusehen, die als Durchtrittsöffnungen für horizontal geführte Kühlluft dienen. Durch Lüfter, die in einem seitlich an den hoch geschirmten Einbauraum angrenzenden schwach geschirmten Bauraum untergebracht sind, lässt sich dadurch eine gute Wärmeabfuhr von den Leiterplatten erzielen.

Der geschirmte Baugruppenträger kann in großen Stückzahlen besonders kostengünstig hergestellt werden, wenn die Abschirmung materialeinheitlich aus einem metallischen Werkstoff als Biege-Stanzteil hergestellt ist. Je nach Einsatzort kann es günstig sein, die Oberfläche der Biege-Stanzteile durch eine galvanische Beschichtung vor Korrosion zu schützen.

Das Zusammenfügen der vormontierten Einheit kann erleichtert werden, wenn an den Führungsrosten und an den Abkantungen der Gehäuseschalen, in Fügerichtung weisende Kontaktnasen bzw. Kontaktwarzen angebracht sind.
Der erfindungsgemäße Baugruppenträger ist für verschiedene Anwendungsbereiche in der Elektrotechnik geeignet. Ein besonders bevorzugtes Einsatzgebiet liegt in der 19-Zoll Reihe, wie sie üblicherweise auch für Kommunikationssysteme verwendet werden.

### Kurzbeschreibung der Zeichnung

Anhand der beigefügten Zeichnungen wird nachstehend ein Ausführungsbeispiel der Erfindung näher erläutert. Es zeigen:
- Figur 1: eine perspektivische Ansicht des erfindungsgemäßen Baugruppenträgers, bei dem die obere Gehäuseschale entfernt ist,
- Figur 2: den Baugruppenträger wie Figur 1 mit montiertem Deckelteil,
- Figur 3: einen stark vergrößerten Ausschnitt des Baugruppenträgers im Bereich der Verbindungsstelle zwischen einem vorderen und einem hinteren Führungsrost,
- Figur 4: den vorderen Führungsrost mit den Ausnehmungen für die Zinken des hinteren Führungsrostes,
- Figur 5: den hinteren Führungsrost mit zungenförmigen Zinken,
- Figur 6: die erfindungsgemäße Vorrichtung ohne Gehäuseschalen in einer Aufsicht.

### Ausführung der Erfindung

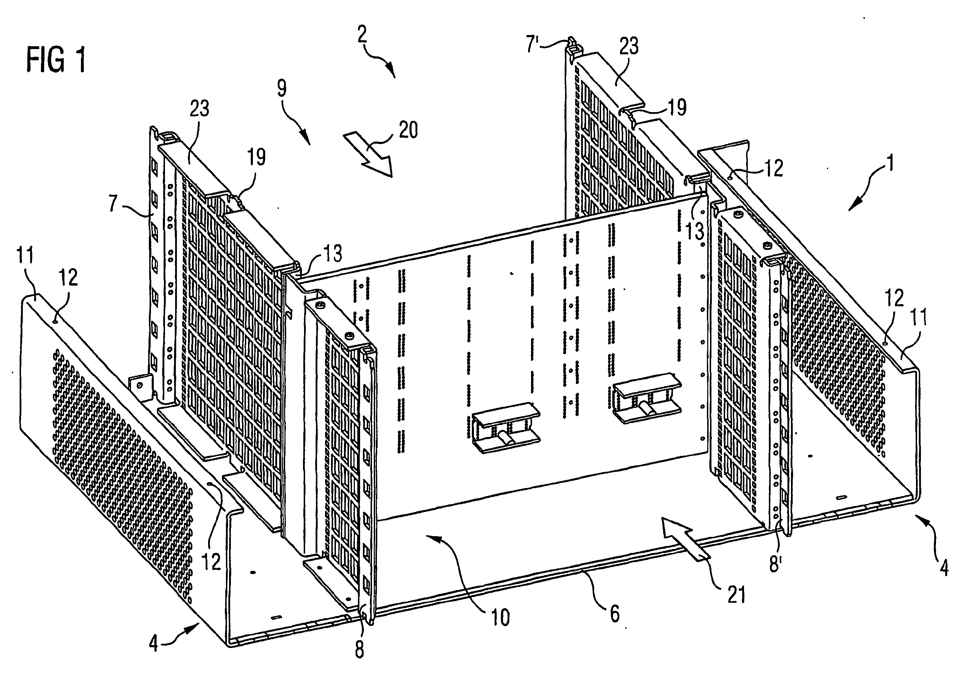

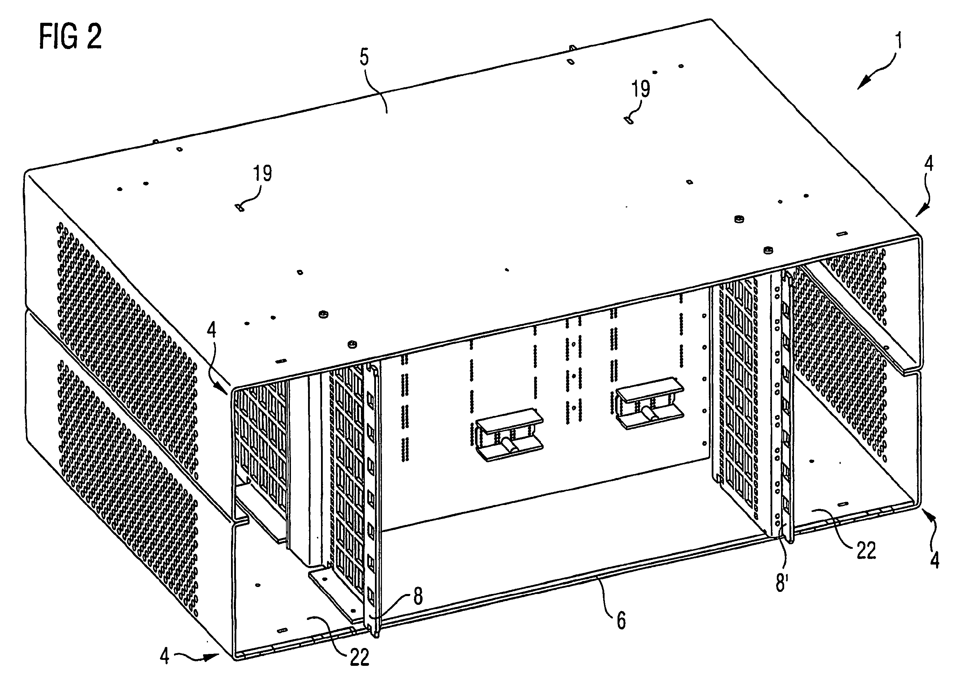

Ein Ausführungsbeispiel des erfindungsgemäßen Baugruppenträgers 1 ist in räumlichen Darstellung in Figur 1 und in Figur 2 dargestellt. In der Zeichnung in Figur 1 ist das Deckelteil 5 abgenommen und der Einbauraum 2 einsehbar. Auf einem Bodenteil 6 sind jeweils paarweise gegenüberliegend Führungsroste 7, 7', 8, 8' angeordnet. Sie bilden seitliche Begrenzungen eines Einbauraums 2. Eine Zwischenwandkarte 3 trennt diesen Einbauraum 2 in einen vorderen Raumabschnitt 9 und in einen hinteren Raumabschnitt 10. Bei der Herstellung des Baugruppenträgers werden in einem ersten Arbeitsschritt die vorderen Führungsroste 7, 7' mit dem Bodenteil 6 und dem Deckenteil 5 durch Punktschweißen verbunden. Hierfür sind an den Führungsrosten decken- und bodenseitig rechtwinkelige Abkantungen 23 vorgesehen. Im Bereich des Schirmraums 2 ist das Deckenteil 5 und das Bodenteil 6 als vollflächige Wand ausgebildet.
An den vorderen Führungsrosten sind decken- und bodenseitig Zentriernasen 19 vorgesehen. Auch an den Vorsprüngen 11 der Abkantungen 4 sind Zentrierwarzen 12 ausgebildet. Die Zentriernasen 19 bzw. die Zentrierwarzen 12 erleichtern bei der Montage das Zusammenfügen der Schirmteile 5, 6, 7, 7', 8, 8'. Durch die Punktschweißungen entsteht eine vormontierte Einheit, bestehend aus den Gehäuseschalen 6 und 5 und den vorderen Führungsrosten 7 und 7'. Diese vormontierte Einheit erleichtert die weitere Montage. Die Zwischenwandkarte 3 ist durch automatisierbare Handhabungssysteme in den hinteren Raumabschnitt 10 einschiebbar und kann an Schenkeln 13 der Führungsroste 7, 7' mittels Schrauben befestigt werden. Die Montagestelle dieser Schraubverbindung ist für Bohrschrauber, die vom hinteren Raumabschnittes 10 zugreifen, gut zugänglich. Anschließend werden im hinteren Raumabschnitt 10 die hinteren Führungsroste 8, 8' mit dem Bodenteil 6 und dem Deckenteil 5 (Fig. 2) verschraubt.
Die Zwischenwandkarte 3 ist außermittig zwischen den vorderen Führungsrosten 7, 7' und den hinteren Führungsrosten 8, 8' angeordnet. Sie erstreckt sich im Einbauraum 2 quer zu den Einschubrichtungen 20 bzw. 21 und wird seitlich durch die Führungsroste begrenzt. Die Führungsroste 7,7', 8,8' bilden seitliche Halterungen für Flachbaugruppen. Diese bestückten Leiterplatten sind jeweils in Führungen im vorderen Raumabschnitt 9 bzw. im hinteren Raumabschnitt 10 einschiebbar. Die Führungen können durch Nuten in den Führungsrosten oder durch Führungsclips, die jeweils in den Führungsrost einrastbar sind, gebildet sein. Die eingeschobenen Leiterplatten werden von beidseitig an der Karte 3 angeordneten Steckverbindern aufgenommen. In Figur 1 ist die Einschubrichtung im vorderen Raumabschnitt 9 durch einen Pfeil mit dem Bezugszeichen 20 gekennzeichnet; der Pfeil 21 zeigt die Einschubrichtung im hinteren Raumabschnitt 10 an.
Das Deckenteil 5, das Bodenteil 6 und die Führungsroste 7,7',8,8' bilden Mantelteile einer elektromagnetischen Abschirmvorrichtung, die stirnseitig durch nicht dargestellte Front- und Rückplatten verschließbar ist.

Wie aus den Darstellungen in Figur 1 und Figur 2 leicht zu entnehmen ist, ist jeweils seitlich zum Einbauraum 2 das Deckenteil 5 und das Bodenteil 6 durch rechtwinkelige Abkantungen 4 zu einer U-förmigen Gehäuseschale fortgesetzt. Dadurch wird seitlich zum Einbauraum 2 jeweils angrenzend ein Bauraum 22 umschlossen, dessen Abschirmwirkung je nach Anforderung unterschiedlich zum Einbauraum 2 ausgeführt werden kann. So kann dieser seitliche Bauraum 22 - verglichen mit dem Einbauraum 2 - schwächer geschirmt werden. Dies kann einfach dadurch erfolgen, das der Abstand der Kontaktpunkte der Punktschweißungen im Fügebereich des abgewinkelten Randes 11 größer und die Kontaktierung der nicht dargestellten stirnseitigen Blenden mit geringerem Aufwand d.h. kostengünstiger ausgeführt werden. Dieser schwach geschirmte seitliche Bauraum 22 ist gut geeignet Lüfter, Stromversorgungen oder Verkabelungen aufzunehmen. Der Bauraum 22 bildet für seitlich eindringende elektromagnetische Wellen eine schirmende Vorkammer. Dem seitlichen Eindringen der elektromagnetischen Wellen sind als Barriere die als Lochwand ausgeführte Abwinkelung 4 und die schirmenden Führungsroste 7 und 8 bzw. 7' und 8' entgegengesetzt. Aus fertigungstechnischer Sicht sind die seitlichen Fortsetzungen am Gehäusedecken- und -bodenteil einfach herstellbar und lassen sich einfach auf unterschiedliche Schirmwirkungen anpassen.

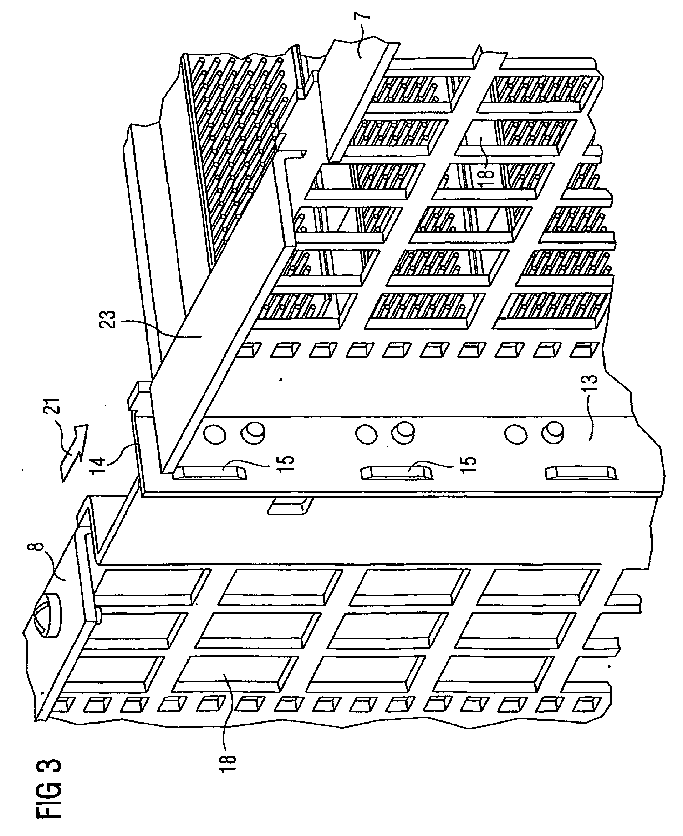

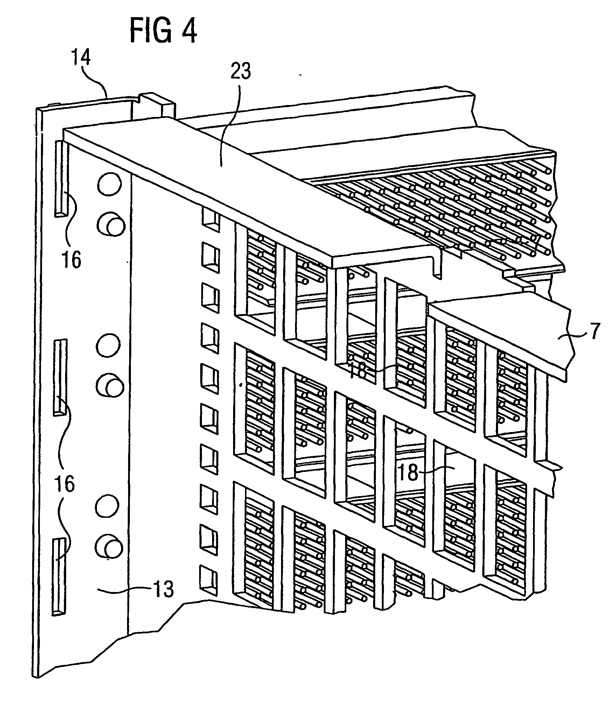

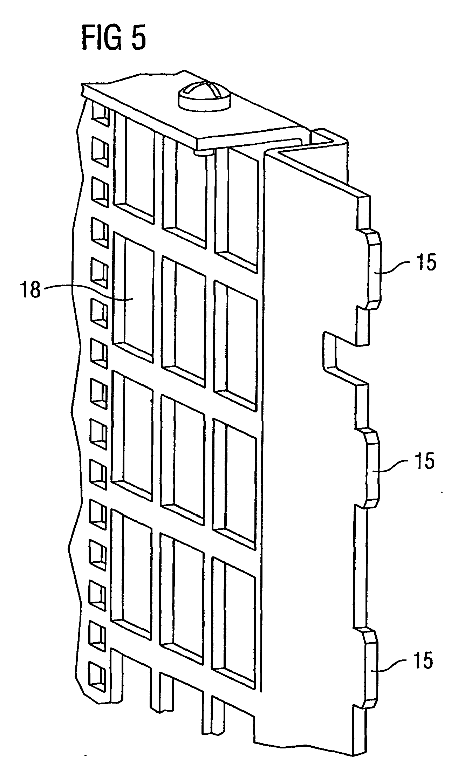

In Figur 3 ist in einer stark vergrößerten Darstellung ein Ausschnitt des Baugruppenträgers 1 im Bereich der Verbindungsstelle zwischen einem vorderen Führungsrost 7 und einen hinteren Führungsrost 8 dargestellt. Der hintere Führungsrost 8 ist in Einschubrichtung 21 endseitig abgekröpft und weist im Endstück zungenförmige Zinken 15 auf. Diese Zinken 15 greifen in korrespondierende Ausnehmungen 16 (Figur 4) eines Schenkels 13 des zugeordneten vorderen Führungsrostes 7 ein. Durch Verdrehen des Endstückes der zungenförmigen Zinken 15 entsteht eine Verschränkung, bei der sich jede Zinke in der Ausnehmung 16 eingräbt und dadurch im Kontaktbereich zumindest punktuell eine annähernd luftdichte Verbindung schafft. Wie in den Figuren 1 bis 5 gezeigt, sind die Führungsroste 7,7',8,8' durch Ausnehmungen 18 freigeschnitten. Diese Ausrisse 18 bilden Durchtrittsöffnungen für horizontal im Baugruppenträger geführte Strömungsluft. In vielen Anwendungsfällen kann bei der erfindungsgemäßen Anordnung eine sehr gute Abschirmeffizienz durch rechteckförmige Durchbrüche mit einer Diagonalen von kleiner als 25 mm erzielt werden.

Die Abkantungen 4 sind als Lochblech ausgebildet, wodurch bei aufeinander gestapelten Baugruppenträgern ein seitlicher Lufteintritt bzw. Luftaustritt möglich ist. Die vielen kleinen Löcher des Lochbleches sind eine günstige Ausführung für eine Be- und Entlüftung des Einbauraums, da sie eine gute Abschirmwirkung besitzen. Form und Größe der Durchbrüche 18 sind entsprechend der abzuschirmenden elektromagnetischen Wellen ausgebildet.

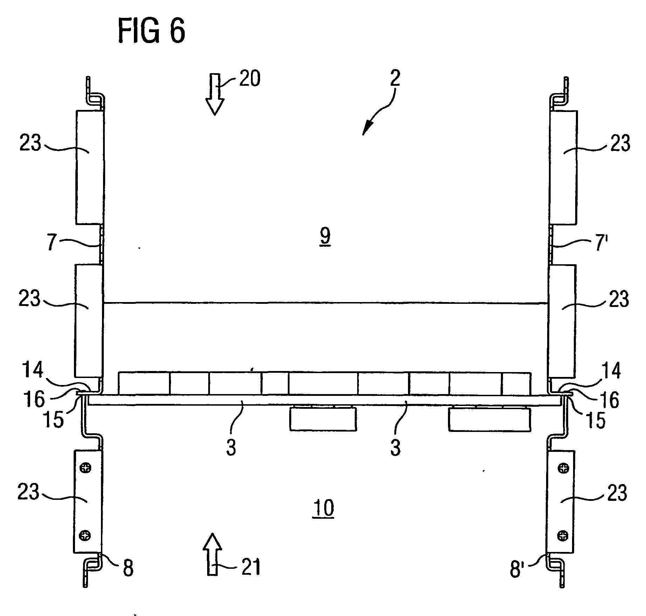

Die Figur 6 veranschaulicht in einer Aufsicht den Schirminnenraum 2, der durch die Zwischenwandkarte 3 in einen vorderen Raumabschnitt 9 und in einen hinteren Raumabschnitt 10 geteilt ist. Die Führungsroste 7 und 8 bzw. 7' und 8' sind paarweise gegenüberliegend und jeweils in Einschubrichtung 20 und 21 gesehen fluchtend angeordnet. Die Zwischenwandkarte 3 ist auf Anlageabschnitten 14 der vorderen Führungsroste 7, 7' durch Schraubverbindungen befestigt. Jeweils an dem zur Karte 3 weisenden Ende weisen die hinteren Führungsroste 8, 8' eine Abkröpfung mit Zinken 15 auf. Die Zinken 15 tauchen in Ausnehmungen 16 der Führungsroste 7, 7' ein. Die Verbindung aufeinander stoßender vorderer und hinterer Führungsroste erfolgt durch Verschränken der Zinken 15 in korrespondierende Ausnehmungen 16. Die Führungsroste 7, 7' sind durch Abkantungen 23 im vorderen Raumabschnitt 9 mit dem Boden- bzw. Deckenteil verschweißt; die Abkantungen 23 der hinteren Führungsroste 8,8' sind im hinteren Raumabschnitt 10, durch Kopf- oder Durchgangschrauben mit dem Decken- bzw.

Bodenteil verschraubt. Die Tiefe des hintere Einbauraums 9 und damit auch die Länge der hinteren Führungsroste 7, 7' ist im dargestellten Ausführungsbeispiel größer als die Tiefe bzw. Länge der Führungsroste 8,8' im hinteren Einbauraum 10. An der Zwischenwandkarte 3 sind auf beiden Seiten Steckverbinder angeordnet. Die Zwischenwandkarte erstreckt sich im Einbauraum 2 quer über alle Einschübe und stellt physikalisch gesehen einen Kommunikationskanal zwischen den Einschüben bereit. Oft ist sie mit einem eigenen Speicher und/oder Mikroprozessor sowie einem Bus zur Abwicklung der Datenübertragung zwischen den Einschüben ausgerüstet. Die Anordnung im erfindungsgemäßen Baugruppenträger 1 ermöglicht es, dass die Zwischenwandkarte 3 durch die leichte Demontierbarkeit der hinteren Führungsroste 8, 8' für Wartungsarbeiten gut zugänglich ist.
Selbstverständlich können mehrere erfindungsgemäße Baugruppenträger in einem mechanischen Gestell, einem sogenannten Rack, übereinander gestapelt angeordnet sein. Üblicherweise beträgt die Breite derartiger Baugruppenträger 19" (48,3 cm).

## Patentansprüche

1. Elektrisch geschirmter Baugruppenträger (1) zur Aufnahme elektrischer und/oder elektronischer Baugruppen mit einem Deckenteil (5) und einem Bodenteil (6), mit zumindest einen Einbauraum (2), den eine Zwischenwandkarte (3) in einen vorderen Raumabschnitt(9) und in einen hinteren Raumabschnitt (10) teilt und in jedem dieser Abschnitte (9, 10) seitlich Halterungen für eingeschobene Flachbaugruppen vorgesehen sind, **dadurch gekennzeichnet, dass** die Halterungen durch paarweise gegenüberliegende Führungsroste (7, 7'; 8, 8') gebildet sind, die in eine elektromagnetische Abschirmung (5, 6, 7, 7', 8, 8') eingebunden sind, wobei das Deckenteil (5) und das Bodenteil (6) mit den Führungsrosten (7, 7') des vorderen Raumabschnitts unlösbar und mit den Führungsrosten (8, 8') des hinteren Raumabschnitts lösbar verbunden sind.

2. Baugruppenträger nach Anspruch 1, **gekennzeichnet durch** ein Deckenteil (5) und ein Bodenteil (6) die jeweils seitlich mit einer Abkantung (4) versehen sind und die jeweils als Gehäuseschale ausgebildet sind.

3. Baugruppenträger nach Anspruch 1 oder 2, **dadurch gekennzeichnet, dass** die Führungsroste (7, 7') im vorderen Raumabschnitt (9) an dem zur Zwischenwandkarte (3) weisenden Ende jeweils mit einem Schenkel (13) versehen sind der einen Anlageabschnitt (14) für die Zwischenwandkarte (3) bildet.

4. Baugruppenträger nach Anspruch 3, **dadurch gekennzeichnet, dass** die Zwischenwandkarte (3) am Anlageabschnitt (14) durch eine Schraubverbindung befestigt ist.

5. Baugruppenträger nach einem der Ansprüche 2 bis 4, **dadurch gekennzeichnet, dass** die Führungsroste (8, 8') des hinteren Raumabschnitts (10) jeweils an dem zur Zwischenwandkarte (3) weisenden Ende mit zungenförmigen Zinken (15) versehen sind, die in korrespondierende Ausnehmungen (16) der Schenkel (13) eingreifen und deren austrittsseitige Enden plastisch verformt sind.

6. Baugruppenträger nach Anspruch 5, **dadurch gekennzeichnet, dass** jedes austrittseitige Ende verschränkt ist.

7. Baugruppenträger nach Anspruch 5 oder 6, **dadurch gekennzeichnet, dass** die Zinken (15) mit einer Anschrägung (17) versehen sind.

8. Baugruppenträger nach zumindest einem der vorstehenden Ansprüche, **dadurch gekennzeichnet, dass** das Deckenteil (5) und das Bodenteil (6) mit den Führungsrosten (7, 7') im vordern Raumabschnitt (9) verschweißt und mit den Führungsrosten (8, 8') des hinteren Raumabschnittes (10) mittels einer Schraubverbindung verbunden sind.

9. Baugruppenträger nach zumindest einem der vorstehenden Ansprüche, **dadurch gekennzeichnet, dass** die Führungsroste (7, 7'; 8, 8') mit Ausnehmungen (18) versehen sind, die Durchtrittsöffnungen für Strömungsluft bilden.

10. Baugruppenträger nach Anspruch 9, **dadurch gekennzeichnet, dass** die Ausnehmungen (18) die Form eines Rechtecks aufweisen und die Diagonale des Rechtecks kleiner als 25 mm ist.

11. Baugruppenträger nach zumindest einem der vorstehenden Ansprüche, **dadurch gekennzeichnet, dass** das Deckenteil (5) und das Bodenteil (6) mit den Führungsrosten (7, 7') durch Schweißpunkte verbunden sind.

12. Baugruppenträger nach Anspruch 11, **dadurch gekennzeichnet, dass** die Schweißpunkte in einem Abstand von kleiner als 25 mm angeordnet sind.

13. Baugruppenträger nach zumindest einem der vorstehenden Ansprüche, **dadurch gekennzeichnet, dass** die Abschirmung (5, 6, 7, 7', 8, 8')aus Biege-Stanzteilen, die materialeinheitlich aus einem metallischen Werkstoff hergestellt sind, gebildet ist.

14. Baugruppenträger nach Anspruch 13, **dadurch gekennzeichnet, dass** die Oberfläche der Biege-Stanzteile galvanisch beschichtet, vorzugsweise verzinkt ist.

15. Baugruppenträger nach zumindest einem der vorstehenden Ansprüche, **dadurch gekennzeichnet, dass** an den Führungsrosten (7, 7'; 8, 8') decken- und bodenseitig Zentriernasen (19) vorgesehen sind.

16. Baugruppenträger nach zumindest einem der vorstehenden Ansprüche, **dadurch gekennzeichnet, dass** die Zwischenwandkarte (3) außermittig angeordnet ist und, jeweils in Einschubrichtung gesehen, die Länge der vorderen Führungsroste 7,7' größer ist, als die Länge der hinteren Führungsroste 8,8'.

17. Baugruppenträger nach zumindest einem der vorstehenden Ansprüche, **dadurch gekennzeichnet, dass** die Flachbaugruppen zumindest einen Teil eines Kommunikationssystems bilden.

## Claims

1. Electrically shielded module carrier (1) for receiving electrical and/or electronic modules with a cover part (5) and a base part (6), with at least one mounting space (2), divided by a partition card (3) into a front space section (9) and a rear space section (10), with lateral supports for inserted plug-in modules provided in each of said sections (9, 10), **characterised in that** the supports are formed by guide lattices (7, 7'; 8, 8') opposite each other in pairs, which are integrated in an electromagnetic shield (5, 6, 7, 7', 8, 8'), with the cover part (5) and the base part (6) being connected permanently to the guide lattices (7, 7') of the front space section and in a detachable manner to the guide lattices (8, 8') of the rear space section.

2. Module carrier according to claim 1, **characterised by** a cover part (5) and a base part (6), each being provided with a lateral folded edge (4) and each being configured as a housing casing.

3. Module carrier according to claim 1 or 2, **characterised in that** the guide lattices (7, 7') in the front space section (9) are each provided with an arm (13) at the end facing the partition card (3), said arm (13) forming a contact section (14) for the partition card (3).

4. Module carrier according to claim 3, **characterised in that** the partition card (3) is secured to the contact section (14) by means of a screw connection.

5. Module carrier according to one of claims 2 to 4, **characterised in that** the guide lattices (8, 8') of the rear space section (10) are each provided with tongue-shaped prongs (15) at the ends facing the partition card (3), said prongs (15) engaging in corresponding recesses (16) in the arms (13) and being subject to plastic deformation at their emerging ends.

6. Module carrier according to claim 5, **characterised in that** each emerging end is interlocked.

7. Module carrier according to claim 5 or 6, **characterised in that** the prongs (15) are provided with a bevel (17).

8. Module carrier according to at least one of the preceding claims, **characterised in that** the cover part (5) and the base part (6) are welded to the guide lattices (7, 7') in the front space section (9) and are connected to the guide lattices in the rear space section (10) by means of a screw connection.

9. Module carrier according to at least one of the preceding claims, **characterised in that** the guide lattices (7, 7'; 8, 8') are provided with recesses (18), which form openings for a through-flow of air.

10. Module carrier according to claim 9, **characterised in that** the recesses (18) are rectangular in shape and the diagonal of the rectangular is smaller than 25 mm.

11. Module carrier according to at least one of the preceding claims, **characterised in that** the cover part (5) and the base part (6) are connected by weld points to the guide lattices (7, 7').

12. Module carrier according to claim 11, **characterised in that** the weld points are disposed at intervals of less than 25 mm.

13. Module carrier according to at least one of the preceding claims, **characterised in that** the shield (5, 6, 7, 7', 8, 8') is formed from cut and bent parts, which are made of the same metal material.

14. Module carrier according to claim 13, **characterised in that** the surfaces of the cut and bent parts are electroplated, preferably galvanised.

15. Module carrier according to at least one of the preceding claims, **characterised in that** centring lugs (19) are provided on the cover and base sides of the guide lattices (7, 7'; 8, 8').

16. Module carrier according to at least one of the preceding claims, **characterised in that** the partition card (3) is disposed off-centre and the length of the front guide lattices (7, 7') is greater than the length of the rear guide lattices (8, 8') in both instances in the direction of insertion.

17. Module carrier according to at least one of the preceding claims, **characterised in that** the plug-in modules form at least part of a communication system.

## Revendications

1. Châssis à modules (1) à blindage électrique pour recevoir des modules électriques et/ou électroniques, comportant une pièce de dessus (5) et une pièce de dessous (6), au moins un espace de montage (2) qu'une carte séparatrice (3) sépare en une portion d'espace avant (9) et en une portion d'espace arrière (10), et des supports latéraux pour des modules plats insérés sont prévus dans chacune de ces portions (9,10), **caractérisé en ce que** les supports sont formés par des grilles de guidage (7, 7' ; 8, 8') qui se font face par paires et sont intégrées dans un blindage (5, 6, 7, 7', 8, 8') électromagnétique, la pièce de dessus (5) et la pièce de dessous (6) étant reliées de manière inamovible aux grilles de guidage (7, 7') de la portion d'espace avant et de manière amovible aux grilles de guidage (8, 8') de la portion d'espace arrière.

2. Châssis à modules selon la revendication 1, **caractérisé par** une pièce de dessus (5) et une pièce de dessous (6), chacune d'elle étant munie latéralement d'une pliure (4) et prenant la forme d'une coque de boîtier.

3. Châssis à modules selon la revendication 1 ou 2, **caractérisé en ce que**, à l'extrémité tournée vers la carte séparatrice (3), chacune des grilles de guidage (7, 7') dans la portion d'espace avant (9) est munie d'une branche (13) qui forme un segment d'appui (14) pour la carte séparatrice (3).

4. Châssis à modules selon la revendication 3, **caractérisé en ce que** la carte séparatrice (3) est fixée par un vissage au segment d'appui (14).

5. Châssis à modules selon l'une des revendications 2 à 4, **caractérisé en ce que** chacune des grilles de guidage (8, 8') de la portion d'espace arrière (10), à l'extrémité tournée vers la carte séparatrice (3), est munie de tenons (15) en languette, qui pénètrent dans des mortaises (16) correspondantes des branches (13) et dont les extrémités vers l'extérieur sont déformées plastiquement.

6. Châssis à modules selon la revendication 5, **caractérisé en ce que** chaque extrémité vers l'extérieur est obtenue par emboîtement.

7. Châssis à modules selon la revendication 5 ou 6, **caractérisé en ce que** les tenons (15) sont munis d'un biseau (17).

8. Châssis à modules selon au moins l'une des revendications précédentes, **caractérisé en ce que** la pièce de dessus (5) et la pièce de dessous (6) sont soudées aux grilles de guidage (7, 7') dans la portion d'espace avant (9) et sont reliées à l'aide d'un vissage aux grilles de guidage (8, 8') de la portion d'espace arrière (10).

9. Châssis à modules selon au moins l'une des revendications précédentes, **caractérisé en ce que** les grilles de guidage (7, 7', 8, 8') sont munies de cavités (18) qui forment des ouvertures de passage pour de l'air en écoulement.

10. Châssis à modules selon la revendication 9, **caractérisé en ce que** les cavités (18) sont des rectangles et la diagonale du rectangle est inférieure à 25 mm.

11. Châssis à modules selon au moins l'une des revendications précédentes, **caractérisé en ce que** la pièce de dessus (5) et la pièce de dessous (6) sont reliées aux grilles de guidage (7, 7') par des points de soudure.

12. Châssis à modules selon la revendication 11, **caractérisé en ce que** les points de soudure ont un écart inférieur à 25 mm.

13. Châssis à modules selon au moins l'une des revendications précédentes, **caractérisé en ce que** le blindage (5, 6, 7, 7', 8, 8') est formé par des pièces découpées et pliées qui sont fabriquées en un seul matériau métallique.

14. Châssis à modules selon la revendication 13, **caractérisé en ce que** la surface des pièces découpées et pliées comporte un revêtement galvanisé, est de préférence zinguée.

15. Châssis à modules selon au moins l'une des revendications précédentes, **caractérisé en ce que** des becs de centrage (19) sont prévus sur les grilles de guidage (7, 7', 8, 8') du côté du dessus et du dessous.

16. Châssis à modules selon au moins l'une des revendications précédentes, **caractérisé en ce que** la carte séparatrice (3) est excentrée et, quand on regarde dans le sens d'insertion, la longueur des grilles de guidage avant (7, 7') est supérieure à la longueur des grilles de guidage arrière (8, 8').

17. Châssis à modules selon au moins l'une des revendications précédentes, **caractérisé en ce que** les modules plats forment au moins une partie d'un système de communication.
